# EUROPEAN PATENT APPLICATION

(11) **EP 1 592 032 A1**
(43) Date of publication of application: **02.11.2005**
(21) Application number: 04360044.4
(22) Date of filing: 30.04.2004
(51) Int. Cl.: H01H 1/00

(54) **Mechanical switching circuit**

(71) Applicant: ALCATEL, 75008 Paris (FR)
(72) Inventor: Schlesinger, Heinz, 73395 Mundelsheim (DE)
(74) Representative: Kohler Schmid Möbus

(57) **Abstract**

A mechanical switching circuit (30) for connecting or disconnecting the connection between a circuit input (31) and a circuit output (32) comprises at least two switching units (39a; 39b) connected in series and each of the switching units (39a; 39b) comprises at least two mechanical switching components (33, 34, 35, 36) connected in parallel.

## Description

### Background of the invention

The invention relates to a mechanical switching circuit for connecting or disconnecting the connection between a circuit input and a circuit output.

Such switching circuits are used, e.g., for switching between different impedance matching circuits and/or bias voltage circuits of power transistors of multi-band RF front-end circuits. The switching is necessary in order to adapt working conditions of these power transistors to different frequency bands.

The switching circuits may be implemented in micro-electro-mechanical (MEMS) technology in order to increase the level of integration. Mechanical switches of this type must be activated (opened and closed) from time to time in order to avoid corrosion (so-called maintenance activation). As many RF front-end circuits operate permanently, it is necessary to effect such a maintenance activation of the mechanical switches without switching-off the circuit.

### Object of the invention

It is the object of the invention to present a mechanical switching circuit which maintains its functionality as a switch when maintenance activation of the mechanical switching circuit is carried through.

### Brief description of the invention

This object is achieved by a mechanical switching circuit for connecting or disconnecting the connection between a circuit input and a circuit output, wherein the mechanical switching circuit comprises at least two switching units connected in series and wherein each of the switching units comprises at least two mechanical switching components connected in parallel.

The invention allows to carry through maintenance activation to one of the mechanical switching components, while the other mechanical switching components are used to maintain the functionality of the switching circuit, i.e. to keep the mechanical switching circuit in an open or in a closed state. The invention accomplishes the object of the invention in a cost-effective manner.

In a preferred embodiment of the inventive device, the mechanical switching components are implemented in MEMS (Micro Micro-Electro-Mechanical Systems) technology. MEMS technology is particularly adapted to RF applications.

In another preferred embodiment, at least one of the mechanical switching components comprises two diagnostic connections between which the switching component is provided.

The invention is also realized in an electronic circuit, in particular a multi-band RF front-end circuit, which comprises at least one mechanical switching circuit according to the invention.

The invention is further realized in a mobile station and/or a base station comprising at least one electronic circuit of the above-mentioned type.

Further advantages may be extracted from the description and the enclosed drawings. The features mentioned above and below may be used in accordance with the invention either individually or collectively in any combination. The embodiments mentioned are not to be understood as an exhaustive enumeration but rather have an exemplary character for the description of the invention.

### Drawings

The invention is shown in the drawings.
- Fig. 1: shows a schematic diagram of a multi-band RF front-end circuit.
- Fig. 2: shows a schematic diagram of a first mechanical switching circuit in accordance with the invention.
- Fig. 3: shows a schematic diagram of a second mechanical switching circuit in accordance with the invention, comprising diagnostic connections.

### Description of the preferred embodiments

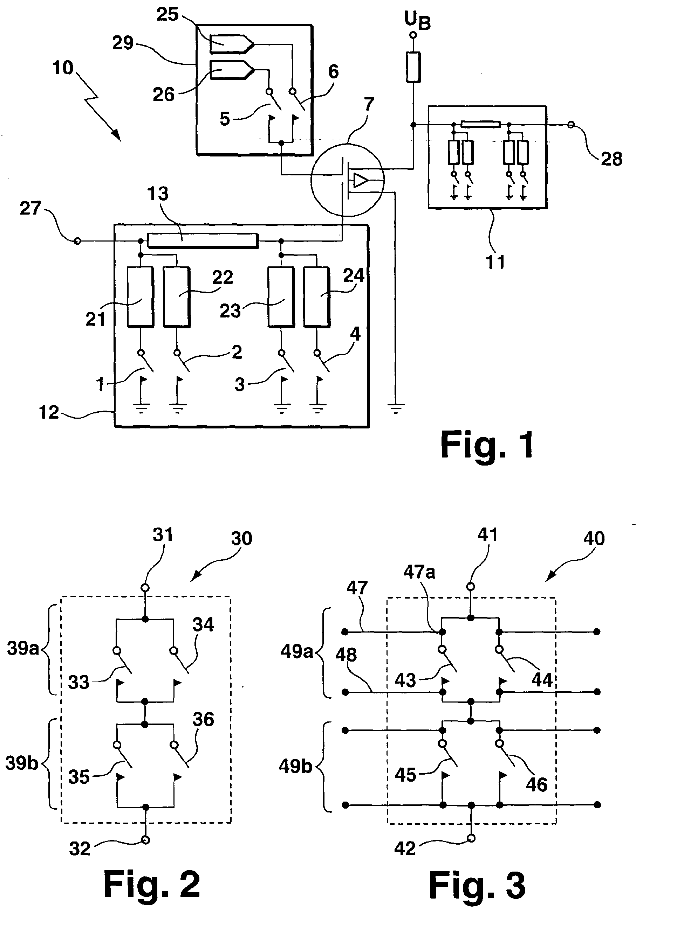

**Fig. 1** shows a schematic diagram of a multi-band RF front-end circuit **10.** A RF signal enters the circuit 10 at an RF input **27,** is amplified by a power transistor **7** and leaves the circuit through an RF output **28** which may be connected to an antenna or another RF amplifying circuit. The power transistor **7** is a dual gate MOSFET, which behaves like a cascade connected pair of MOSFETS and which comprises a first gate for the input of an RF signal and a second gate for the input of a bias voltage.

In the path of the RF signal, between the RF input 27 and the first gate of the power amplifier 7, an input-side impedance matching circuit **12** is provided. Likewise, an output-side impedance matching circuit **11** is provided in the path of the RF signal between the drain of the power amplifier 7 and the RF output 28. The two impedance matching circuits 11, 12 are used to adapt the power transistor 7 to its electrical environment (usually 50 Ohm), in dependence of a selected frequency band.

A bias voltage circuit **29** is connected to the second gate of the power amplifier 7 providing a bias input voltage to the power amplifier 7 depending on a selected frequency band. As usual in RF amplification circuits, a battery voltage U_{B} is connected to the drain of the power amplifier 7 via a resistor and the source of the power amplifier 7 is connected to mass.

The input-side impedance matching circuit 12 and the output-side impedance matching circuit 11 have an identical layout. In the following, it is therefore sufficient to describe the layout of the input-side impedance matching circuit 12.

The input-side matching circuit 12 comprises a resistor **13** connecting the RF input 27 and the first gate of the power transistor 7. A first and second matching resistor **21, 22** are connected to the RF input side of the resistor 13. Either of the two matching resistors 21, 22 is connected in series to one of two mechanical switches **1,2** which connect or disconnect mass to the first and second matching resistors 21, 22. In the same way, a third and fourth matching resistor **23, 24** are connected to the power amplifier side of the resistor 13 and are connected in series to a third and a fourth mechanical switch **3**, **4** which connect or disconnect the third and fourth matching resistors to mass.

The bias voltage circuit 29 provides a first and a second bias voltage at a first and a second voltage input **25, 26.** The first and second voltage inputs 25, 26 are connected in series to a fifth and a sixth switch **5, 6** connecting or disconnecting the first and/or second bias voltage to the bias voltage input of the power amplifier 7.

The multi-band RF front-end circuit 10 is construed for operating (non-simultaneously) with at least two RF bands of above 1 GHz. The power transistor 7 shows optimal performance only over a small frequency range of approximately 100 MHz. Therefore, the switches 1 through 6 are used in order to optimize the performance of the power transistor 7 depending on the selected RF band. An example for on/off positions of the switches 1 to 6 in dependence of RF frequency bands is shown in the following table:

| band | type | switch 1 | switch 2 | switch 3 | switch 4 | switch 5 | switch 6 |
|---|---|---|---|---|---|---|---|
| 1 | DCS | on | off | on | off | off | on |
| 2 | UMTS | off | on | off | on | on | off |

The multi-band RF front-end circuit 10 is operated continuously, especially when used in a base station of a mobile radio system, such as a UMTS system. The switches 1 through 6 have to be activated (opened, closed) from time to time in order to avoid corrosion. As the multi-band RF front-end circuit 10 does not have an operation downtime, it is necessary to accomplish maintenance activation of the switches 1 to 6 and at the same time to maintain their switching functionality, as described above.

In order to achieve this object, the layout of the switches 1 through 6 may be designed in the manner shown in **Fig. 2,** namely as a switching circuit 30 implemented in MEMS technology. The switching circuit 30 comprises a first switching unit **39a** and a second switching unit **39b.** A circuit input **31** is connected to the first switching unit 39a, the latter being connected in series to the second switching unit 39b. The second switching unit is connected to a circuit output **32.** Each of the two switching units 39a, 39b comprises a first and second mechanical switching component 33, 34, 35, 36 connected in parallel.

The mechanical switching circuit 30 may be used to implement anyone of the switches 1 through 6 of Fig. 1. In the following, it is supposed that the mechanical switching circuit 30 is implemented as switch 1 of the multi-band RF front-end circuit 10. Therefore, during operation of the front-end circuit 10 with the RF band 1 of the above table, the switching circuit 30 has to be maintained in a closed state, i.e. it has to keep up connection between the circuit input 31 and the circuit output 32.

This functionality is attained if the fist switching component 33 of the first switching unit 39a is in a closed state and, at the same time, also the first switching component 35 of the second switching unit 39b is in a closed state. In this case, maintenance activation can be applied to the second switching component 34 of the first switching unit 39a and/or the second switching component 36 of the second switching unit 39b.

Of course, it is also possible to exchange the role of the first and the second switching components, such that it is possible to apply maintenance activation to the first switching components 33, 35 of both switching units 39a, 39b. In summary, maintenance activation can be applied to all of the four switching components 33, 34, 35, 36 of the mechanical switching circuit 30 while the connection between the circuit input 31 and the circuit output 32 is maintained.

During operation of the front-end circuit 10 with the RF band 2 of the above table, the switching circuit 30 has to be in an open state, i.e. the circuit input 31 and the circuit output 32 have to be disconnected. For this purpose, the first and the second switching component 33, 34 of the first switching unit 39a may be switched to the open state, while maintenance activation is applied to the first and second switching components 35, 36 of the second switching unit 39b.

Of course, it is also possible to bring the first and second switching component of the second switching unit 39b to an open state and to apply maintenance activation to the first and second switching components 33, 34 of the first switching unit 39a. In summary maintenance activation can be applied to all of the four switching components 33, 34, 35, 36 of the mechanical switching circuit 30 while the circuit input 31 and the circuit output 32 are disconnected.

The object of the invention is thus achieved both, when the mechanical switching circuit 30 is in an open state as well as if the mechanical switching circuit is in a closed state. It should be clear that the object of the invention may also be attained if more than two switching units are connected in series and also if one or more of the switching units comprise more than two switching components which are connected in parallel.

A second mechanical switching circuit 40 in accordance with the invention is shown in **Fig. 3,** which comprises all of the features of the mechanical switching circuit 30 of Fig. 2. Therefore, features of Fig. 3 identical to features of Fig. 2 are referred to with the numerals used in Fig. 2 raised by ten. In addition to the features of Fig. 2, the embodiment of Fig. 3 shows diagnostic connections between which the mechanical switching components 43, 44, 45, 46 are provided. The mechanical switching component 43 is provided, for example, between a first and a second diagnostic connection **47**, **48** through which a defined direct current can be applied to the switching component 43. In this case, a measurement of the voltage between the first and the second connection 47, 48 allows to supervise the switching component and to detect errors in the functionality of the switching component 43. Alternatively, the diagnostic connections may be used in order to connect additional elements to the mechanical switching components, thus influencing a frequency response of the mechanical switching circuit 40.

It should be clear that the use of the inventive device is not limited to multi-band RF front-end circuits and that it may also be applied for implementing mechanical switches, especially in MEMS technology, in a variety of technical fields.

## Claims

1. A mechanical switching circuit (30; 40) for connecting or disconnecting the connection between a circuit input (31; 41) and a circuit output (32; 42),
**characterized in that**
the mechanical switching circuit (30; 40) comprises at least two switching units (39a; 39b; 49a, 49b) connected in series and that each of the switching units (39a; 39b; 49a, 49b) comprises at least two mechanical switching components (33, 34, 35, 36; 43, 44, 45, 46) connected in parallel.

2. Switching circuit according to claim 1, **characterized in that** the mechanical switching components (33, 34, 35, 36; 43, 44, 45, 46) are implemented in MEMS technology.

3. Switching circuit according to claim 1, **characterized in that** at least one of the mechanical switching components (43, 44, 45, 46) comprises two diagnostic connections (47, 48) between which the switching component is provided.

4. Electronic circuit (10), in particular multi-band RF front-end circuit, comprising at least one mechanical switching circuit (30; 40) according to claim 1.

5. Mobile station comprising at least one electronic circuit (10) according to claim 4.

6. Base station comprising at least one electronic circuit (10) according to claim 4.
